# EUROPEAN PATENT APPLICATION

(11) **EP 4 318 602 A1**
(43) Date of publication of application: **07.02.2024**
(21) Application number: 22775351.4
(22) Date of filing: 16.03.2022
(51) Int. Cl.: H01L 31/0224, H01B 1/22

(54) **ELECTRICALLY CONDUCTIVE PASTE, SOLAR CELL ELECTRODE, AND SOLAR CELL**

(30) Priority: 26.03.2021 JP 2021053168
(71) Applicant: Namics Corporation, Niigata-shi, Niigata 950-3131 (JP)
(72) Inventor: KOBAYASHI, Kenji, Niigata-shi, Niigata 950-3131 (JP); MURAMATSU, Kazuo, Niigata-shi, Niigata 950-3131 (JP); TANABE, Hideo, Niigata-shi, Niigata 950-3131 (JP)
(74) Representative: Hoffmann Eitle
(86) International application number: PCT/JP2022/011997
(87) International publication number: WO 2022/202563

(57) **Abstract**

Provided is a conductive paste for forming a solar cell electrode capable of forming an electrode having a low specific resistance and a reduced possibility of disconnection. It is a conductive paste for forming an electrode of a solar cell, wherein the conductive paste comprises: a conductive particles (A); an epoxy resin (B); and a curing agent (C), the conductive particles (A) contain a conductive component and two or more organic components, and the conductive component is silver, and the curing agent (C) contains at least one selected from an imidazole-based curing agent and a boron trifluoride compound.

## Description

### FIELD OF THE INVENTION

The present invention relates to a conductive paste capable of obtaining a conductive pattern excellent in electrical characteristics. Specifically, it relates to the conductive paste that can be used for electrode formation of a semiconductor device such as a solar cell.

### BACKGROUND ART

Conductive pastes containing silver particles are used, for example, to form an electrode and a circuit pattern for semiconductor devices and electronic components. The formation of an electrode and a circuit pattern by the conductive paste can be performed by applying a conductive paste of a predetermined pattern onto a substrate or the like by a screen printing method or the like, and then heating the conductive paste to obtain a conductive film of a predetermined pattern.

There are two types of conductive paste, i.e., high-temperature firing type conductive pastes and thermosetting conductive pastes. High-temperature firing type conductive pastes are pastes which are capable of forming conductive films by being fired at a high temperature of about 550 to 900 degrees C. In the case of a high-temperature firing type conductive paste, the resin component contained in the conductive paste is burned off during firing. Thermosetting conductive pastes are pastes that can form conductive films by heating at a relatively low temperature of about room temperature (around 20 degrees C) to 250 degrees C. In the case of thermosetting conductive paste, the resin component is cured and silver particles are bonded together to form a conductive film.

For example, in Patent Document 1, a conductive paste for forming an electrode of a solar cell containing conductive particles, an organic vehicle and a specific glass frit is described.

In addition, as a thermosetting conductive paste, Patent Document 2 describes a thermosetting conductive paste composition containing a conductive powder of a flaky powder and a spherical powder, a thermosetting component composed of epoxy resin with a component A and a component B, a curing agent and a solvent.

### Prior Art Documents

### Patent Documents

Patent document 1: JP 2017-10628 A
Patent document 2: JP 2013-196954 A

### DISCLOSURE OF THE INVENTION

Thermosetting conductive paste generally uses epoxy resin as a binder. In order to achieve both good adhesion and good electrical properties (resistivity less than 10 µΩ·cm), heat treatment more than 250 degrees C is generally required.

Thermosetting conductive paste may be used to form an electrode for a solar cell. To obtain a solar cell with high conversion efficiency, it is necessary to reduce the width of an electrode and to reduce an electrical resistance of the electrode. By reducing the width of the electrode formed on a surface where sunlight is incident, the incident area of sunlight can be increased. In addition, by reducing the electrical resistance (specific resistance) of the electrode, the power loss when the generated current flows through the electrode can be reduced.

Generally, when the shape of the conductive particles included in a conductive paste for forming an electrode is a scale shape (flake shape), the specific resistance of the electrode can be reduced compared with the case where the shape of the conductive particles is a spherical shape. However, when the conductive particles having a scale shape (flake shape) are used, the possibility of disconnection of the electrode increases. When the conductive particles having a spherical shape are used, although the fear of disconnection of the electrode can be reduced, it is known that the resistivity is generally high as described above.

Therefore, it is an object of the present invention to provide a conductive paste for forming a solar cell electrode capable of forming an electrode having a low resistivity and a reduced possibility of disconnection.

To solve the above problem, the present invention has the following configurations.

### (Configuration 1)

Configuration 1 of the present invention is a conductive paste for forming an electrode of a solar cell,
wherein the conductive paste comprises:
a conductive particles (A);
an epoxy resin (B); and
a curing agent (C),
the conductive particles (A) contain a conductive component and two or more organic components, and the conductive component is silver, and
the curing agent (C) contains at least one selected from an imidazole-based curing agent and a boron trifluoride compound.

### (Configuration 2)

Configuration 2 of the present invention is the conductive paste of the configuration 1, wherein the organic component comprises carboxylic acid.

### (Configuration 3)

Configuration 3 of the present invention is the conductive paste of the configuration 1, wherein the organic component comprises at least one selected from fatty acid ether or salt thereof and benzotriazole.

### (Configuration 4)

Configuration 4 of the present invention is the conductive paste of the configuration 1, wherein the organic component comprises carboxylic acid and at least one selected from fatty acid ether or salt thereof and benzotriazole.

### (Configuration 5)

Configuration 5 of the present invention is the conductive paste of the configuration 1, wherein the organic component comprises one or more organic component α and one or more organic component β,
the conductive particles (A) comprise the organic component α inside the conductive particles (A) and the organic component β on a surface of the conductive particles (A),
the organic component α comprises at least one selected from fatty acid ether, salt of fatty acid ether and benzotriazole.

### (Configuration 6)

Configuration 6 of the present invention is the conductive paste of the configuration 5, wherein the organic component β comprises stearic acid or ricinoleic acid.

### (Configuration 7)

Configuration 7 of the present invention is the conductive paste of any one of the configurations 3 to 6, wherein the fatty acid ether or the salt thereof comprises at least one selected from palmitic acid ether, myristic acid ether and oleic acid ether.

### (Configuration 8)

Configuration 8 of the present invention is the conductive paste of any one of the configurations 1 to 7, wherein a BET specific surface area of the conductive particles (A) is 0.3 to 3.5 m²/g.

### (Configuration 9)

Configuration 9 of the present invention is the conductive paste of any one of the configurations 1 to 8, wherein the conductive particles (A) comprise spherical conductive particles and a weight ratio of the spherical conductive particles in the conductive particles (A) is 80 weight % or more.

### (Configuration 10)

Configuration 10 of the present invention is any one of the conductive pastes of the configurations 1 to 9, wherein a weight ratio of the conductive particles (A) and total weight of epoxy resin (B) and curing agent (C) (the weight of the conductive particles (A) : the total weight of epoxy resin (B) and curing agent (C)) is 98.5 : 1.5 to 93.0 : 7.0.

### (Configuration 11)

Configuration 11 of the present invention is any one of the conductive pastes of the configurations 1 to 10, wherein the conductive paste comprises 0.1 to 5.0 parts by weight of the curing agent (C) when the total weight of the conductive particles (A) and the epoxy resin (B) is 100 parts by weight.

### (Configuration 12)

Configuration 12 of the present invention is any conductive paste of the configurations 1 to 11, wherein the conductive paste further comprises a solvent (D).

### (Configuration 13)

Configuration 13 of the present invention is the conductive paste according to any one of the configurations 1 to 12 for forming an electrode of a solar cell, wherein a wiring width of the electrode of the solar cell is 20 to 60 µm.

### (Configuration 14)

Configuration 14 of the present invention is the electrode of the solar cell comprising the electrode having a wiring width of 20 to 60 µm in the solar cell, wherein the electrode is obtained by heat treatment of the conductive paste according to any one of the configurations 1 to 13.

### (Configuration 15)

Configuration 15 of the present invention is the solar cell, wherein the electrode of the solar cell comprises a cured product obtained by heat treatment of the conductive paste according to any one of the configurations 1 to 13.

According to the present invention, it is possible to provide a conductive paste for forming a solar cell electrode capable of forming an electrode having a low resistivity and a reduced possibility of disconnection.

### BRIEF DESCRIPTION OF THE DRAWINGS

[Fig. 1] Fig. 1 is a cross-sectional schematic diagram illustrating an example of a solar cell having electrodes formed using a conductive paste.
[Fig. 2] Fig. 2 is a plan diagram illustrating a pattern for measuring resistivity for an electrode formed with a conductive paste.

### MODE FOR CARRYING OUT THE INVENTION

Embodiments of the present invention will now be described in detail with reference to the drawings. The following embodiments are embodiments for embodying the present invention and are not intended to limit the invention to the scope thereof.

The conductive paste of the present embodiment is a thermosetting conductive paste. The conductive paste of the present embodiment can be thermoset at a low temperature (e.g., 250 degrees C or less) to form an electrode by containing a predetermined components. By using the conductive paste of the present embodiment, it is possible to form a conductive film (electrode) with a low specific resistance and a reduced possibility of disconnection. The conductive paste of the present embodiment is preferably used as a conductive paste for forming an electrode of a solar cell.

In the present specification, the term "conductive film" refers to a thin-film-shaped pattern in which a conductive paste is printed or the like on a surface of a predetermined substrate or the like to form a pattern of a predetermined shape and cured. The pattern of the predetermined shape includes a pattern of any shape, for example, a linear shape, a dot shape and a planar shape. The conductive film can be used as an electrode.

The conductive paste of the present embodiment can be used to form an electrode and a circuit pattern of semiconductor devices and electronic components. The conductive paste of the present embodiment can be used to form an electrode and/or a circuit pattern not only on a surface of inorganic material such as a semiconductor, oxide and ceramics, but also on a substrate with low heat tolerance such as PET (polyethylene terephthalate) and PEN (polyethylene naphthalate).

As used herein, the term "semiconductor device" means a device using a semiconductor chip, such as a semiconductor device such as a transistor and an integrated circuit, a flat panel display such as a liquid crystal display (LCD) and a plasma display panel (PDP), and a device using a semiconductor such as a solar cell. A semiconductor device is a device utilizing the properties of electrons and holes in a semiconductor and has an electrode for direct or indirect electrical connection to the semiconductor.

An electrode of semiconductor devices may require light transmission. A transparent conductive film is used as a material for such electrode. An electrode made of a transparent conductive film is called a transparent electrode. The transparent electrode is used in flat panel displays such as liquid crystal displays (LCD) and plasma display panels (PDP), and in semiconductor devices such as various solar cells. Examples of the solar cells include thin film solar cells such as amorphous silicon solar cells and compound semiconductor solar cells (CIS (CuInSe₂) solar cells, CIGS (Copper Indium Gallium Selenide) solar cells, and CdTe solar cells, etc.), heterojunction solar cells, and crystalline silicon solar cells. The transparent electrodes are used for electrode formation in, for example, flat panel displays, thin-film solar cells, heterojunction solar cells and the like.

An oxide conductive film can be used as a transparent conductive film as a material for a transparent electrode. An indium tin oxide (Also referred to ITO (Indium Tin Oxide)) thin film, a tin oxide thin film, and a ZnO-based thin film can be used as the oxide conductive film. At present, ITO thin films are often used in flat panel displays and various solar cells. A grid of electrodes (it is sometimes referred to simply as "an electrode".) is formed to provide an electrical connection to the transparent electrode so as not to prevent light from entering or exiting the semiconductor device. The conductive paste of the present embodiment can be used to form a grid of electrodes on a surface of the transparent electrode.

Depending on the type of material of the semiconductor of the semiconductor device, the type of material of the electronic component, and the type of material other than the semiconductor which constitutes the semiconductor device and the electronic component, etc., the semiconductor chip and/or other materials may deteriorate if the electrode is treated at a high temperature, for example, above 250 degrees C, in the electrode formation process. By using the conductive paste of the present embodiment, it is possible to form an electrode having a low specific resistance at a low temperature (e.g., 250 degrees C or less). By using the conductive paste of the present embodiment, it is possible to form an electrode having a predetermined low resistance without deteriorating the semiconductor device at a high temperature.

When an electrode is formed on a transparent conductive film using the conductive paste of the present embodiment, a low contact resistance can be obtained. In particular, when an electrode is formed on an ITO thin film, a low contact resistance (e.g., a contact resistance of 8 mΩ·cm² or less) can be obtained relatively easily. Therefore, the conductive paste of the present embodiment can be suitably used to form an electrode on a transparent conductive film, especially an ITO thin film.

The conductive paste of the present embodiment can be preferably used to form an electrode on a surface of a transparent conductive film of a solar cell. Depending on the type of a solar cell, a material adversely affected by a high-temperature heating process may be used. The conductive paste of the present embodiment may be preferably used to form an electrode on a surface of a transparent conductive film of such a low heat tolerance solar cell. Amorphous silicon may be one of the materials adversely affected by the high-temperature heating process. As a solar cell using amorphous silicon as a material, an amorphous silicon solar cell and a heterojunction solar cell using amorphous silicon and crystalline silicon (hereinafter referred to simply as a "heterojunction solar cell".) may be mentioned. The conductive paste of the present embodiment can preferably be used to form an electrode on a surface of a transparent conductive film of an amorphous silicon solar cell and a heterojunction solar cell. The conductive paste of the present embodiment can be used to form an electrode of a solar cell with low resistivity and reduced possibility of disconnection.

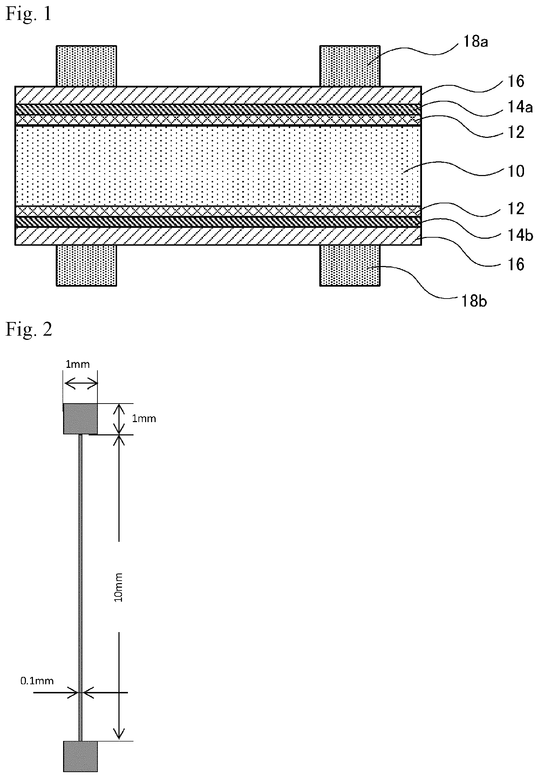

Referring to Fig. 1, a heterojunction solar cell which is a preferred application of the conductive paste of the present embodiment will be described.

Fig. 1 is a cross-sectional schematic diagram of an example of a heterojunction solar cell. In the heterojunction solar cell shown in Fig. 1, an i-type amorphous silicon layer 12 (film thickness about 10 nm) made of intrinsic amorphous silicon and a p-type amorphous silicon layer 14a (film thickness about 10 nm) made of p-type amorphous silicon are stacked in this order on the light-incident side surface of an n-type crystalline silicon substrate 10 (for example, a single crystalline silicon substrate or a polycrystalline silicon substrate). A transparent conductive film 16 (film thickness about 70 nm) made of, for example, indium tin oxide (ITO) is arranged on the p-type amorphous silicon layer 14a. A grid of light incident side electrodes 18a is formed on a surface of the transparent conductive film 16 in order to obtain a slit-like light incident side surface.

As shown in Fig. 1, an i-type amorphous silicon layer 12 (film thickness about 10 nm) made of intrinsic amorphous silicon and an n-type amorphous silicon layer 14b (film thickness about 10 nm) made of heavily doped n-type amorphous silicon are stacked on the back surface of the crystalline silicon substrate 10 in this order. A transparent conductive film 16 and a grid-shaped back side electrode 18b are formed on the n-type amorphous silicon layer 14b in the same manner as the light incident side surface.

In the case of the heterojunction solar cell shown in Fig. 1, the respective layers other than the crystalline silicon substrate 10 can all be formed at a temperature of about 200 degrees C or less using a method such as a plasma CVD method, a sputtering method, a deposition method, or a screen printing method. Since amorphous silicon is adversely affected by a high-temperature heating process, the temperature at which the light incident side electrode 18a and the back side electrode 18b are formed on the surface of the transparent conductive film 16 is preferably low. If the conductive paste of the present embodiment is used, the light incident side electrode 18a and the back side electrode 18b can be formed at a low temperature (e.g., 250 degrees C or less) with a low specific resistance and a reduced possibility of disconnection.

Next, the conductive paste of the present embodiment will be described.

The conductive paste for forming an electrode of a solar cell of the present embodiment includes conductive particles (A), an epoxy resin (B), and a curing agent (C). The conductive paste of the present embodiment may further include a solvent (D). Hereinafter, each component included in the conductive paste of the present embodiment will be described.

### <Conductive Particles (A)>

The conductive paste of the present embodiment includes conductive particles (A). The conductive particles (A) include a conductive component and two or more kinds of organic components.
(A) The conductive component included in the conductive particles can be a metal such as silver, copper, nickel, aluminum, zinc and/or tin. Since the resistivity is relatively low and easy to obtain, the conductive component is preferably silver, and the conductive component is more preferably composed of silver. The conductive component is more preferably consisting of silver only.

The term "the conductive component is consisting of silver only" means that substantially all of the conductive component is silver except for the inevitable presence of impurities. That is, when the conductive component is consisting of silver only, the conductive component can contain inevitable presence of impurities other than silver. The same applies to other components other than the conductive component.

The conductive particles (A) contain two or more organic components. The organic components may be included in the conductive particles (A) together with the conductive components as raw materials in the production of the conductive particles (A). Further, by surface treatment using an organic component, the organic component may be included on the surface of the particles produced using the conductive particles (A) (and the organic component) as raw a material.

The method for producing the conductive particles containing two or more kinds of the organic components may be any method provided that the conductive particles (A) contain the conductive components and two or more kinds of the organic components. For example, the first method for producing the conductive particles containing two or more kinds of the organic components may be a method of producing the particles consisting of the conductive components (e.g., silver particles) first, and then treating the surface of the particles consisting of the conductive components with two or more kinds of the organic components. The second method for producing the conductive particles containing two or more kinds of the organic components may be a method of producing the conductive particles (A) containing two or more kinds of the organic components using a raw material containing the conductive components and two or more kinds of the organic components. The third method for producing the conductive particles containing two or more kinds of the organic components may be a method containing producing the conductive particles (A) containing one or more kinds of organic component (organic component α) in the same manner as the second method described above, and treating the surface of the conductive particles (A) with one or more kinds of organic component (organic component β) in the same manner as the first method. By using the third manufacturing method, it is possible to manufacture conductive particles (A) having a structure in which the organic component α is incorporated into the conductive particles and the organic component β is present on the surface of the conductive particles (A). In order for the organic component α to be incorporated into conductive particles (A), it is necessary to intentionally add a predetermined amount of the organic component α when the conductive particles (A) are manufactured.

Preferably, the conductive particles are porous bodies having voids therein. The presence of voids in the conductive particles enables the organic component (organic component α) to be contained in the conductive particles. The tap density of the conductive particles is preferably 2.0 to 8.0 g/cm³, more preferably 2.5 to 7.0 g/cm³, and particularly preferably 3.0 to 6.0 g/cm³. With the tap density in this range, an electrode having sufficient conductivity can be formed.

In the first method for producing conductive particles containing two or more kinds of the organic components, a method for producing particles (e.g., silver particles) composed of conductive components is not particularly limited. For example, a reduction method, a pulverization method, an electrolysis method, an atomization method, a heat treatment method, or a combination thereof can be used.

In the second and third production methods of conductive particles containing two or more kinds of the organic components, the following production method can be used, for example, to produce conductive particles (A) containing one or more kinds of organic component using a raw material containing a conductive component and an organic component. In the following example, a production method for producing silver particles having a conductive component of silver and containing an organic component will be described. In the following description, the organic component contained in the conductive particles (A) is referred to as an organic component α, and the organic component contained on the surface of the conductive particles (A) is referred to as an organic component β. The conductive particles (A) preferably contain both of the organic component α and the organic component β.

A silver ammonia complex salt solution, an additive, and a reducing agent are used as a raw material as a manufacturing method for producing the silver particles with the organic component in which the conductive component is silver, and the silver particles with the organic component can be produced as follows.

First, an aqueous solution containing the silver ammonia complex salt (a silver ammonia complex aqueous solution) is prepared. The silver ammonia complex aqueous solution can be formed by adding ammonia water to the silver nitrate aqueous solution. Since the coordination number of ammonia in the silver ammonia complex is 2, it is preferable to add more than 2 moles of ammonia per mole of silver.

Next, an organic component (the organic component α) is added to the silver ammonia complex aqueous solution before reducing the silver ammonia complex salt with a reducing agent. The organic component α may include at least one selected from fatty acid ether, salt of fatty acid ether and benzotriazole. By adding the organic component α prior to reduction of silver, aggregation of silver powder after reduction can be suppressed and the organic component α can be incorporated into the conductive particles (A).

The organic component α is not particularly limited and can be appropriately selected according to the purpose. The organic component can be added directly or as an aqueous solution dissolved in water. The amount of the organic component α added is preferably 0.1 to 2.0 mass %, and more preferably 0.5 to 1.0 mass %, with respect to the amount of silver to be reduced. If the amount of the organic component α added is too small, the effect of inhibiting aggregation cannot be obtained, and if the amount of the organic component α added is too large, it is difficult to obtain silver particles efficiently because the reduction of silver is inhibited.

Next, silver is reduced and deposited by adding a reducing agent to an aqueous solution of a silver ammonia complex containing the organic component α. As a reducing agent, there is no particular limitation. For example, formalin and hydrazine can be mentioned as reducing agents. Preferably, hydrazine is used as reducing agent. By using reducing agent, spherical silver powder with a suitable particle size can be efficiently obtained. The amount of reducing agent added is preferably 1 equivalent or more to silver.

The silver powder obtained by reduction deposition is collected by filtration and washing. Pure water is preferably used as the cleaning liquid. The method of collection and cleaning is not particularly limited. The washed silver powder is preferably dried in a hot air dryer or the like.

Thus, the silver particles containing the organic components can be produced by reductive deposition of silver from an aqueous solution of a silver ammonia complex containing organic component α. By incorporating a predetermined amount of the organic component α into the conductive particles (A), the conductive particles (A) described above can be preferably used as a raw material for a conductive paste for forming a solar cell electrode. By using a conductive paste containing the conductive particles (A) described above, it is possible to form an electrode (a solar cell electrode) with a low specific resistance and a reduced possibility of disconnection.

Next, an example of a method of surface treatment using an organic component (organic component β) on the surface of a particle (e.g., a silver particle) made of a conductive component produced by the first manufacturing method or on the surface of a conductive particle including an organic component produced by the third manufacturing method will be described.

As an example of a method of surface treatment using an organic component β, by adding a surface treatment agent including an organic component to a slurry containing a conductive particle, an organic component included in the surface treatment agent can be adsorbed on the surface of the conductive particle. In the case where silver is reductively deposited from an aqueous solution of a silver ammine complex containing an organic component (the first organic component α) as described above, when a surface treatment agent containing the second organic component β is added during the reductive deposition of silver, the second organic component β is adsorbed on the surface of the silver particles and the grain growth of the silver particles can be stopped.

The surface treatment agent containing the organic component β is not particularly limited and can be appropriately selected according to the purpose. The organic component β for the surface treatment is preferably stearic acid or ricinoleic acid.

The amount of the surface treatment agent including the organic component β is preferably 0.05 to 3 weight % based on the weight of the conductive component (e.g., silver), and more preferably 0.1 to 1 weight %.

As described above, the surface of the particles comprising the conductive component (e.g., silver particles) produced by the first manufacturing method or the surface of the conductive particles comprising the organic component produced by the third manufacturing method can be surface treated using the organic component.

Since the conductive particles (A) included in the conductive paste of the present embodiment contain the conductive component (e.g., silver) and two or more kinds of the organic components, when the electrode is formed using the conductive paste, an electrode having a low specific resistance can be obtained.

In the conductive paste of the present embodiment, the organic component α preferably contains at least one selected from fatty acid ether or salt thereof and benzotriazole. The organic component is preferably contained within conductive particles produced by the first and third production methods described above. When the organic component is a predetermined organic component, it can be more certain that an electrode having a low specific resistance is obtained. It should be noted that fatty acid ether is, for example,

H₂ₘ₊₁Cₘ-O-(CH₂-CH₂-O)ₙ-H

wherein "m" indicates the carbon number of the alkyl group (12 to 15) and "n" indicates the number of added moles of ethylene oxide.

In the conductive paste of the present embodiment, the organic component β preferably contains carboxylic acid that is a compound containing a carboxyl group. The carboxylic acid is preferably at least one selected from the above-mentioned stearic acid and ricinoleic acid. In order to contain the carboxylic acid in the conductive particles (A), it is preferable to use the second method or the third method for producing the conductive particles containing the organic component. When the organic component β contains the carboxylic acid, the specific resistance can be lowered by advancing the fusion of the conductive particles during heating.

Fatty acid ether includes palmitic acid ether, myristic acid ether, oleic acid ether, and the like. The fatty acid ether or its salt preferably contains at least one of palmitic acid ether, myristic acid ether, and oleic acid ether. It may also contain a plurality of components selected from palmitic acid ether, myristic acid ether, oleic acid ether, and the like. In the case of including a plurality of components, it is preferable that the component of palmitic acid ether is more than the other components (for example, myristic acid ether, oleic acid ether, etc.).

The conductive paste of the present embodiment is preferable that the organic component includes carboxylic acid and at least one selected from fatty acid ether or its salt and benzotriazole.

As described above, the carboxylic acid of the organic component is preferably at least one selected from stearic acid and ricinoleic acid. In addition, in order to include the carboxylic acid in the conductive particles (A), it is preferable to use the manufacturing method described in the second manufacturing method or the third manufacturing method of the conductive particles including the organic component (method for producing conductive particle containing organic component by using raw material containing a conductive component and an organic component(s)). Accordingly, the carboxylic acid such as stearic acid and ricinoleic acid is preferably included on the surface of the conductive particles.

As described above, at least one of the organic components selected from fatty acid ether or salt thereof and benzotriazole is preferably included inside the conductive particles. This step is included in the first and third manufacturing methods described above. Thus, by using the third manufacturing method described above, it is more preferable that the conductive particles (A) include carboxylic acid, preferably at least one selected from stearic acid and ricinoleic acid, on the surface of the conductive particles, and at least one selected from fatty acid ether or salt thereof and benzotriazole inside the conductive particles. By including such conductive particles (A) in the conductive paste of the present embodiment, it is further ensured that an electrode having a low specific resistance is obtained.

According to the present embodiment, it is possible to obtain a conductive paste capable of forming an electrode having a low specific resistance and a reduced possibility of disconnection.

The shape of the conductive particles can be, for example, spherical, flaky, or needle-like. Conductive particles with different shapes can be mixed and used. Flake-shaped conductive particles can be produced, for example, by crushing spherical conductive particles by ball milling or the like.

In the conductive paste of the present embodiment, the conductive particles (A) preferably contain spherical conductive particles (spherical shaped conductive particles). Further, the weight ratio of the spherical conductive particles in the conductive particles (A) is preferably 80 weight % or more, more preferably 90 weight % or more, more preferably 95 weight % or more, more preferably 99 weight % or more. It is particularly preferable that the conductive particles (A) are substantially composed of spherical conductive particles. The risk of electrode disconnection can be reduced when spherical conductive particles are used, compared to when scale-like (flake-like) conductive particles are used. However, it is generally known that the resistivity is high when spherical conductive particles are used. The conductive particles (A) included in the conductive paste of the present embodiment include the conductive component and two or more kinds of the organic components, as described above. Therefore, in spite of the spherical shape of the conductive particles (A) included in the conductive paste of the present embodiment, it is possible to form an electrode with a low specific resistance and a reduced possibility of disconnection.

In addition, in the case of the conductive paste for forming the electrode with fine wiring (for example, the wiring width is 20 to 60 µm), it is particularly preferable that the conductive particles (A) are substantially made of spherical conductive particles. The use of spherical conductive particles is more advantageous for forming the electrode with fine wiring because it is easier to control the particle size and has fewer coarse particles than flake silver.

The preferred average particle size of the conductive particles (A) is 0.05 µm to 15 µm, more preferably 0.1 µm to 5 µm, and more preferably 0.2 µm to 3 µm. In the present specification, the average particle size refers to the average particle size based on the number criterion by laser diffraction scattering particle size distribution measurement (average particle size of 50% integrated value of all particles: D50). When the average particle size of the conductive particles is in the above range, the surface condition of the electrode and circuit pattern obtained by heating the conductive paste becomes good. In addition, the electrical characteristics of the electrode and circuit pattern obtained by heating the conductive paste are improved.

In the conductive paste of the present embodiment, the BET specific surface area of the conductive particles (A) is preferably 0.3 to 3.5 m²/g, more preferably 0.3 to 3 m²/g, and more preferably 0.4 to 2.5 m²/g. By making the BET specific surface area of the conductive particles (A) an appropriate range, the electrical characteristics of an electrode and a circuit pattern obtained by heating the conductive paste are improved.

The content of conductive particles (A) included in the conductive paste of the present embodiment is preferably 75 to 99 weight %, more preferably 80 to 96 weight %, and more preferably 85 to 94 weight % relative to the entire conductive paste.

### <Epoxy resin (B)>

The conductive paste of the present embodiment includes epoxy resin (B).

Examples of epoxy resins include high-molecular bisphenol A epoxy resins, branched polyfunctional bisphenol A epoxy resins such as p-glycidyloxyphenyl dimethyl tris-bisphenol A diglycidyl ether, bisphenol F epoxy resins, biphenyl epoxy resins such as diglycidyl biphenyl, novolak epoxy resins, tetrabromobisphenol A epoxy resins, tris(hydroxylphenyl)methane epoxy resins, alicyclic epoxy resins such as vinyl(3,4-cyclohexene) dioxide, (3,4-epoxycyclohexyl)methyl 3,4-epoxycyclohexylcarboxylate, bis(3,4-epoxy-6-methylcyclohexylmethyl) adipate and 2-(3,4-epoxycyclohexyl) 5,1-spiro(3,4-epoxycyclohexyl)-m-dioxane, glycidyl ester epoxy resins such as diglycidyl hexahydrophthalate, diglycidyl 3-methylhexahydrophthalate and diglycidyl hexahydroterephthalate, glycidyl amine epoxy resins such as diglycidyl aniline, diglycidyl toluidine, triglycidyl-p-aminophenol, tetraglycidyl-m-xylylenediamine and tetraglycidyl bis(aminomethyl)cyclohexane, hydantoin epoxy resins such as 1,3-diglycidyl-5-methyl-5-ethylhydantoin, epoxy resins having a silicone skeleton such as 1,3-bis(3-glycidoxypropyl)-1,1,3,3-tetramethyldisiloxane.

The epoxy resin (B) included in the conductive paste of the present embodiment preferably contains at least one selected from phenol novolak epoxy resin, bisphenol F epoxy resin, biphenyl epoxy resin and bisphenol A epoxy resin. The epoxy resin (B) preferably substantially composed of at least one selected from phenol novolak epoxy resin, bisphenol F epoxy resin, biphenyl epoxy resin and bisphenol A epoxy resin. By using a predetermined epoxy resin as the epoxy resin (B), the thermosetting resin can be thermally cured at a low temperature (e.g., 250 degrees C or less).

### <Curing agent (C)>

The conductive paste of the present embodiment includes curing agent (C). The curing agent (C) preferably includes at least one selected from an imidazole-based curing agent and a boron trifluoride compound. The boron trifluoride compound includes boron trifluoride monoethylamine, boron trifluoride piperidine, boron trifluoride diethyl ether, and the like. Particularly, boron trifluoride monoethylamine is preferably used from the viewpoint of specific resistance and adhesion strength.

Preferably, the curing agent (C) included in the conductive paste of the present embodiment includes at least one selected from the imidazole of Formula (1), Formula (2) and Formula (3).

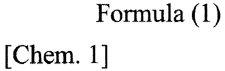

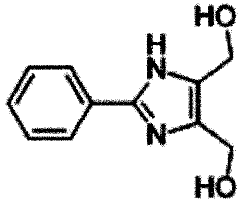

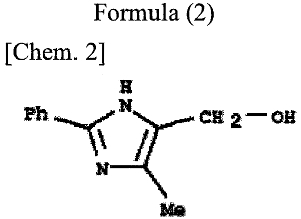

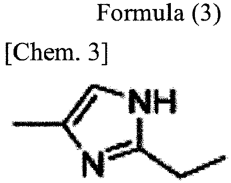

When the conductive paste of the present embodiment contains a curing agent (C) containing at least one selected from the imidazoles of the formulae (1), (2) and (3), the specific resistance of the resulting conductive film (for example, a solar cell electrode) can be made lower.

The conductive paste of the present embodiment preferably further contains phenolic resin as a curing agent (C). When the conductive paste of the present invention further contains phenolic resin in addition to the imidazole described above, heat curing at a low temperature (e.g., 250 degrees C or less) can be more ensured.

The phenolic resin is not particularly limited, but it is preferable to use a phenolic resin such as, for example, a resol type phenolic resin, an alkyl resol type phenolic resin, a novolak type phenolic resin, an alkyl novolak type phenolic resin, and/or an aralkyl novolak type phenolic resin.

In the conductive paste of the present embodiment, the ratio of the weight of the conductive particles (A) and the total weight of the epoxy resin (B) and the curing agent (C) (the weight of the conductive particles (A) : (the total weight of the epoxy resin (B) and the curing agent (C))) is preferably 98.5 : 1.5 to 93.0 : 7.0 and preferably 98.4 : 1.6 to 93.5 : 6.5. By appropriately controlling the weight of the conductive particles (A) and the ratio of the total weight of the epoxy resin (B) and the curing agent (C), it is possible to form an electrode with a low specific resistance and a reduced possibility of disconnection.

When the total weight of the conductive particles (A) and the epoxy resin (B) is 100 parts by weight, the conductive paste of the present embodiment preferably contains the curing agent (C) of 0.1 to 5.0 parts by weight, more preferably 0.15 to 4.0 parts by weight and more preferably 0.2 to 3.5 parts by weight. By setting the weight ratio of the curing agent (C) to a predetermined range, the epoxy resin (B) can be cured appropriately, and an electrode having a desired shape can be obtained.

### <Solvent (D)>

In the conductive paste of the present embodiment, the conductive paste preferably further contains solvent (D). When the conductive paste contains solvent, the viscosity of the conductive paste can be set to an appropriate range and the screen printing performance can be enhanced.

As an example of a solvent contained in the conductive paste of the present embodiment, aromatic hydrocarbons such as toluene, xylene, mesitylene and tetralin; ethers such as tetrahydrofuran; ketones such as methyl ethyl ketone, methyl isobutyl ketone, cyclohexanone and isophorone; lactams such as 2-pyrrolidone and 1-methyl-2-pyrrolidone; ether alcohols such as ethyl glycol monophenyl ether, ethylene glycol monomethyl ether, ethylene glycol monoethyl ether, ethylene glycol monobutyl ether, diethylene glycol monomethyl ether, diethylene glycol monoethyl ether, diethylene glycol monobutyl ether (butyl carbitol), and propylene glycol derivatives corresponding to the above ethers; esters, such as acetate esters, corresponding to the above ethers (for example, butyl carbitol acetate); and diesters such as methyl esters or ethyl esters of dicarboxylic acids such as malonic acid and succinic acid can be mentioned. Among them, at least one selected from ethylene glycol monophenyl ether and butyl carbitol acetate can be preferably used.

The conductive paste of the present embodiment preferably contains ethylene glycol monophenyl ether or butyl carbitol acetate as the solvent (D).

By containing ethylene glycol monophenyl ether or butyl carbitol acetate as the solvent (D), it is possible to more reliably obtain a conductive film (for example, a solar cell electrode) of low specific resistance. Further, by using a predetermined solvent, the viscosity of the conductive paste can be more appropriately adjusted, and the printing characteristics of the printed conductive film can be improved. Specifically, when the pattern of the conductive film is a thin line shape, the line width can be made thin and constant, the film thickness can be made constant, and the shape can be a high aspect ratio.

When the conductive paste of the present embodiment is applied to a surface such as a transparent conductive film by screen printing, the apparent viscosity of the conductive paste at ambient temperature is preferably 100 to 1000 Pa s, more preferably 200 to 900 Pa·s, and more preferably 300 to 800 Pa·s. The viscosity can be measured at a rotational speed of 5rpm (shear speed: 2 sec⁻¹) and a temperature of 25 degrees C using a Brookfield viscometer: HBD type (manufactured by Brookfield Corporation). The viscosity of the conductive paste can be set to a predetermined range by adjusting the mixing amount of solvent (D) in the conductive paste.

### < Other components>

The conductive paste of the present embodiment may contain the following components in addition to the aforementioned components (A), (B), (C) and (D).

The conductive paste of the present embodiment may contain a thermosetting resin other than epoxy resin. As examples of such thermosetting resins, amino resins such as urea resin, melamine resin, and guanamine resin.; oxetane resin; phenolic resin such as resol type phenolic resin, alkyl resol type phenolic resin, novolak type phenolic resin, alkyl novolak type phenolic resin, and aralkyl novolak type phenolic resin; silicone modified resin such as silicone epoxy, and silicone polyester; bismaleimide, polyimide resin and the like can be mentioned.

The conductive paste of the present embodiment can include a thermoplastic resin. Examples of thermoplastic resins include novolak phenolic resins, allyl phenolic resins, phenoxy resins, butyral resins, cellulose resins, acrylic resins, methacrylic resins, polyester resins, polyurethane resins, polyamide resins, thermoplastic xylene resins, hydroxystyrene-based polymers, cellulose derivatives, and mixtures of two or more of these.

The conductive paste of the present embodiment may further contain a phenolic resin as a thermosetting resin or a thermoplastic resin. The conductive paste of the present embodiment may further contain a phenolic resin to ensure thermosetting of the thermosetting resin at a low temperature (e.g., 250 degrees C or less).

The conductive paste of the present embodiment preferably further contains a coupling agent (F). By further containing the coupling agent, the adhesive property between inorganic components such as conductive particles and a thermosetting resin can be improved.

The conductive paste of the present embodiment can further contain at least one selected from the group consisting of inorganic pigments, organic pigments, leveling agents, thixotropic agents, and antifoaming agents.

### <Method for producing conductive paste>

The method for producing the conductive paste of the present embodiment is not particularly limited. The conductive paste of the present embodiment can be produced by pouring each component in predetermined proportion into a mixer such as a grinding kneader, a propeller stirrer, a kneader, a three-roll mill, a pot mill and the like.

The conductive paste of the present embodiment can be applied to a surface of a transparent electrode and the like by a known method such as a screen printing method. After the conductive paste is applied to a surface of a transparent electrode and the like, the conductive paste is heated to a predetermined temperature and cured to form a conductive film.

The heating temperature for the thermal curing of the conductive paste is preferably 250 degrees C or less and more preferably 200 degrees C or less at the time of electrode formation. Specifically, the heating temperature for the thermal curing of the conductive paste is preferably 100 to 250 degrees C, more preferably 120 to 200 degrees C and more preferably 150 to 200 degrees C.

The thickness of the conductive paste applied to a surface of a transparent electrode and the like is preferably 5 to 40 µm, more preferably 10 to 30 µm and further preferably 15 to 20 µm.

The conductive paste of the present embodiment can preferably be used to form an electrode for a solar cell having a wiring width of 20 to 60 µm. Therefore, the electrode of the solar cell subjected to heat treatment of the conductive paste of the present embodiment can include an electrode having a wiring width of 20 to 60 µm. The width (wiring width) of the conductive paste applied to a surface of a transparent electrode and the like is preferably 20 to 60 µm, more preferably 20 to 50 µm, and further preferably 20 to 40 µm.

The conductive film obtained by heating the conductive paste of the present embodiment has features such as high adhesion strength to the substrate, low specific resistance (high conductivity), and low contact resistance. Therefore, by using the thermosetting conductive paste of the present embodiment, it is possible to form a good electrode for a semiconductor device, etc., without deterioration of the semiconductor device, etc., due to high temperature.

The conductive paste of the present embodiment can be used for forming an electrode, a circuit pattern, etc., of the semiconductor device, and electronic components, etc. The conductive paste of the present embodiment can be used for forming a circuit pattern and an electrode not only on a semiconductor substrate, and ceramic substrate, etc., but also on a substrate with low heat tolerance such as PET (polyethylene terephthalate) and PEN (polyethylene naphthalate).

When an electrode is formed on the surface of a transparent conductive film such as an ITO thin film using the thermosetting conductive paste of the present embodiment, a low contact resistance can be obtained. In particular, when an electrode is formed on an ITO thin film, a low contact resistance (e.g., a contact resistance of 8 mΩ ·cm² or less) can be obtained relatively easily. Therefore, the thermosetting conductive paste of the present embodiment can be suitably used to form an electrode on the surface of a transparent conductive film, especially a transparent electrode made of an ITO thin film as a material.

The conductive paste of the present embodiment can be preferably used as a conductive paste for forming a solar cell electrode. In particular, the conductive paste of the present embodiment can be preferably used as a conductive paste for forming an electrode of a solar cell using a thin film material such as an amorphous silicon system, for example, an amorphous silicon solar cell, a heterojunction solar cell, and a compound semiconductor solar cell (CIS solar cells, CIGS solar cells, CdTe solar cells, etc.). The thin film material such as an amorphous silicon system is vulnerable to high temperatures. By using the conductive paste of the present embodiment, it is possible to form an electrode with a relatively low temperature, a low specific resistance, and a reduced possibility of disconnection. The conductive paste of the present embodiment is particularly preferable for forming an electrode of a heterojunction solar cell, as shown in Fig. 1, which has a relatively high conversion efficiency.

In the conductive paste for forming the solar cell electrode of the present embodiment, it is preferable that the heat treatment temperature at the time of forming the electrode is 250 degrees C or less, and more preferably 200 degrees C or less. By forming the electrode at the heat treatment temperature of such a temperature, it is possible to suppress the adverse effect on the thin film material which is vulnerable to high temperature. By the heat treatment of the conductive paste, it is possible to form a cured product. The electrode of the solar cell preferably contains a cured product of the conductive paste of the present embodiment. According to the present embodiment, it is possible to obtain a solar cell having an electrode having a low resistivity and a reduced possibility of disconnection. Therefore, the conversion efficiency of the solar cell can be increased.

### EXAMPLE

Examples and Comparative Examples of the present embodiment will be described below.

### [Preparation of conductive pastes]

As Examples and Comparative Examples, conductive pastes containing conductive particles (A), an epoxy resin (B), a curing agent (C), and a solvent (D) were produced. Tables 1 to 4 show the proportions of Examples 1 to 25 and Comparative Examples 1 to 6. The proportions shown in Tables 1 to 4 are expressed as 100 parts by weight of conductive particles (A).

### Conductive particles (A)

As the conductive particles, conductive particles A to J shown in Table 5 were used in the proportions shown in Tables 1 to 4. The conductive components of the conductive particles A to J are all silver.

In the conductive particles A to D, salt of fatty acid ether (organic component α) was incorporated into the silver particles during the production of the silver particles, and the surface of the silver particles was treated with stearic acid (organic component β) to form spherical silver powder.

The conductive particles E were similar to the conductive particles A to D, but benzotriazole (organic component α) was used instead of the salt of fatty acid ether. Ricinoleic acid (organic component β) was used instead of stearic acid.

As the silver particles of conductive particles F, spherical silver powder containing no organic component and no surface treatment of silver particles was used.

As the silver particles of conductive particles G, spherical silver powder containing no organic component but surface treatment of silver particles with oleic acid was used. Therefore, the silver particles of conductive particles G contain one of an organic component.

The silver particles of the conductive particles H used benzotriazole for producing the silver particles. Therefore, the silver particles of the conductive particles H contain one of an organic component.

The silver particles of the conductive particles I do not contain any organic component inside, and the surface of the silver particles is made of flaky silver powder which is surface-treated with oleic acid, and they were produced in-house. Therefore, the silver particles of the conductive particles I contain one of an organic component. For the flake silver powder, a mixture of 1000 g of spherical silver powder, 20 g of oleic acid, and 100 g of ethanol was stirred in a pot mill for a predetermined time, and then filtered by suction with filter paper to remove the ethanol. The flake silver powder was then dried in a dryer maintained at 60 degrees C for 24 hours to produce the flake silver powder.

For the silver particles of the conductive particles J, fatty acid ether was used to produce the silver particles, but the spherical silver powder was produced in-house without surface treatment of the silver particles. Therefore, the silver particles of the conductive particles J contain one of an organic component. The spherical silver powder was produced as follows. That is, 150 g of silver nitrate was added into 6 liters of pure water and dissolved by increasing the liquid temperature to 60 degrees C while stirring, and 40 ml of ammonia water was added to make a yellow-transparent complex salt solution. A polycarboxylic acid alkylamine salt was added to the complex salt solution, and 30 g of hydrazine was added while stirring to precipitate silver particles. Decant was repeated with pure water, and the water was sufficiently removed by suction filtration with filter paper. Next, the powder was dried in a dryer kept at 60 degrees C for 24 hours to completely remove the water, and spherical silver powder was obtained.

The type and content of organic components contained in the conductive particles can be determined using a Fourier transform infrared spectrophotometer (FT-IR) and a gas chromatograph mass spectrometer (GC-MS).

### (B) Epoxy Resin

The following epoxy resins A and B were used as epoxy resins in the proportions shown in Tables 1 to 4.

Epoxy resin A: Phenol novolak epoxy resin (Model number: JER154, manufactured by Mitsubishi Chemical)

Epoxy Resin B: Bisphenol F epoxy resin (Model number: EXA835LV, manufactured by DIC Corporation)

### Curing Agent (C)

Curing agents A to F shown in Table 6 were used as curing agents in the proportions shown in Tables 1 to 4. The imidazole-based curing agents A to C are curing agents containing imidazole shown by the following chemical formula.
Curing agent A (imidazole-based curing agent 1): Imidazole of formula (1) 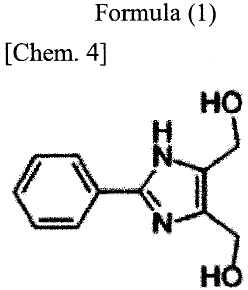
Curing agent B (imidazole-based curing agent 2): Imidazole of formula (2) 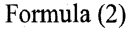 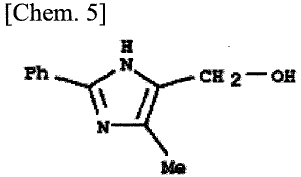
Curing agent C (imidazole-based curing agent 3): Imidazole of formula (3) 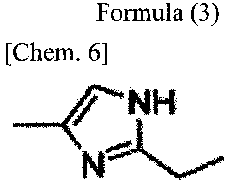
Curing agent D: Boron trifluoride monoethylamine complex (a curing agent of model number BF3 manufactured by Fujifilm (Wako))
Curing agent E: Allylphenol resin (a curing agent of model number MEH8000 H manufactured by Meiwa Kasei Co., Ltd)
Curing agent F: Novolak type phenolic resin (a curing agent of model number PSM4324 manufactured by Gunei Chemical Industry Co., Ltd.)

### Solvent (D)

As a solvent, the following 2 solvents A and B were used in the proportions shown in Tables 1 to 4.
Solvent A: Ethylene glycol monophenyl ether
Solvent B: Butyl carbitol acetate

### [Measurement of specific resistance]

The specific resistance of the conductive film obtained by heating the conductive paste of Examples 1 to 25 and Comparative Examples 1 to 6 was measured.

The specific resistance of Examples and Comparative Examples was measured by the following procedure. That is, a silicon substrate having a width of 15 mm, a length of 15 mm, and a thickness of 180 µm was prepared. On this substrate, a 325 mesh stainless steel screen was used to print a pattern consisting of conductive paste as shown in Fig. 2.

Next, the pattern consisting of conductive paste of Examples and Comparative Examples applied on the substrate was heated at 200 degrees C for 30 minutes to obtain samples for resistivity measurement.

The resistivity of the conductive film patterns of the samples for resistivity measurement obtained by heating the conductive pastes of Examples and Comparative Examples was measured. First, the resistivity was measured by the 4-terminal method using Multimeter 2001 manufactured by TOYO Corporation. The cross-sectional area of the pattern was measured using a confocal microscope OPTELICS H1200 manufactured by Lasertec Corporation and a surface roughness profiler 1500SD2. Fifty places in a range of 1.6 mm were measured, and the average value was obtained. The specific resistance was calculated with the cross-sectional area and the measured resistance value.

Four samples of the same condition were prepared as the samples for resistivity measurement, and the measured values were obtained as the average values of the four samples. Tables 1 to 4 show the measurement results.

As evident from Tables 1 to 4, the specific resistance of the conductive films obtained by using the conductive pastes of Examples 1 to 25 of the present embodiment was 8.8 µΩ·cm (Example 4) or less. Generally, a specific resistance of 10 µΩ·cm or less can be said to be suitable for use as an electrode. In contrast, the specific resistance of the conductive films obtained by using the conductive pastes of Comparative Examples 1 to 6 ranged from 11 µΩ·cm (Comparative Example 6) to 8684 µΩ·cm (Comparative Example 1). Therefore, it became clear that a lower specific resistance can be obtained by forming the conductive films using the conductive pastes of Examples 1 to 25 of the present embodiment.

### [Evaluation of Printing Characteristics]

The conductive paste of Examples and Comparative Examples was printed by a screen printer as a pattern having a width of 22 µm and a length of 46 mm on a surface of a silicon substrate on which an ITO thin film was formed. The printing conditions were 1.5 mm of clearance, 70 N printing of pressure, 65 degrees of squeegee angle, and 250 mm/sec of squeegee speed using a 360 mesh stainless steel screen with a 17 µm emulsion thickness. The printed patterns were cured using a hot air dryer at 200 degrees C for 45 minutes to obtain printed patterns for measurements of shapes.

The printing characteristics was evaluated by measuring the shapes of the printed patterns for the measurements of shapes. The shapes of the patterns for contact resistance measurement were measured using confocal microscope OPTELICS H1200 manufactured by Lasertec Corporation and a surface roughness profiler 1500SD2. Fifty places in a range of 1.6 mm were measured, and the pattern with a minimum film thickness of 3 µm or less at least one measurement place was judged as "broken."

As shown in Tables 1 to 4 as "good", the printing characteristics of the conductive pastes of Examples 1 to 25 and Comparative Example 2 to 5 on a surface of a transparent conductive film (ITO thin film) were good even with fine wiring of 22 µm width and 46 mm length. However, in Comparative Examples 1 and 6, since there was a measured place with a minimum film thickness of 3 µm or less, it was judged as "disconnection."

**[Table 1]**

| | | Example 1 | Example 2 | Example 3 | Example 4 | Example 5 | Example 6 | Example 7 | Example 8 |
|---|---|---|---|---|---|---|---|---|---|
| (A) Conductive particles | Conductive particles A | 100 | 100 | 100 | 100 | | | | |
| | Conductive particles B | | | | | 100 | | | |
| | Conductive particles C | | | | | | 100 | | |
| | Conductive particles D | | | | | | | 100 | |
| | Conductive particles E | | | | | | | | 100 |
| | Conductive particles F | | | | | | | | |
| | Conductive particles G | | | | | | | | |
| | Conductive particles H | | | | | | | | |
| | Conductive particles | | | | | | | | |
| | Conductive Particles J | | | | | | | | |
| (B) Epoxy resin | Epoxy resin A | 0.96 | 1.43 | 2.38 | 3 | 1.43 | 1.43 | 1.43 | 1.43 |
| | Epoxy resin B | | | | | | | | |
| (C) Curing agent | Curing agent A | 0.21 | 0.31 | 0.52 | 0.65 | 0.31 | 0.31 | 0.31 | 0.31 |
| | Curing agent B | | | | | | | | |
| | Curing agent C | | | | | | | | |
| | Curing agent D | | | | | | | | |
| | Curing agent E | 0.8 | 1.2 | 2 | 2.52 | 1.2 | 1.2 | 1.2 | 1.2 |
| | Curing agent F | | | | | | | | |
| (D) Solvent | Solvent A | 7 | 7 | 7 | 7 | 7 | 7 | 7 | 7 |
| | Solvent B | | | | | | | | |
| Weight ratio (A) / [(B) + (C)] | | 98.1/ 1.9 | 97.1/ 2.9 | 95.3/ 4.7 | 94.0/ 6.0 | 97.1/ 2.9 | 97.1/ 2.9 | 97.1/ 2.9 | 97.1/ 2.9 |
| Viscosity (Pa·sec) | | 660 | 640 | 620 | 590 | 400 | 380 | 700 | 730 |
| Specific resistance (µΩ·cm) | | 4.2 | 4.8 | 7.3 | 8.8 | 5.7 | 6.8 | 4 | 4.7 |
| Printability | | Good | Good | Good | Good | Good | Good | Good | Good |

**[Table 2]**

| | | Comparative Example 1 | Comparative Example 2 | Comparative Example 3 | Comparative Example 4 | Comparative Example 5 | Comparative Example 6 | Example 9 |
|---|---|---|---|---|---|---|---|---|
| (A) Conductive particles | Conductive particles A | | | | | 100 | | 100 |
| | Conductive particles B | | | | | | | |
| | Conductive particles C | | | | | | | |
| | Conductive particles D | | | | | | | |
| | Conductive particles E | | | | | | | |
| | Conductive particles F | 100 | | | | | | |
| | Conductive particles G | | 100 | | | | 70 | |
| | Conductive particles H | | | 100 | | | | |
| | Conductive particles I | | | | | | 30 | |
| | Conductive Particles J | | | | 100 | | | |
| (B) Epoxy resin | Epoxy resin A | 1.43 | 1.43 | 1.43 | 1.43 | 1.43 | 1.43 | |
| | Epoxy resin B | | | | | | | 1.43 |
| (C) Curing agent | Curing agent A | 0.31 | 0.31 | 0.31 | 0.31 | | | 0.31 |
| | Curing agent B | | | | | | | |
| | Curing agent C | | | | | | | |
| | Curing agent D | | | | | | | |
| | Curing agent E | 1.2 | 1.2 | 1.2 | 1.2 | 1.2 | 1.2 | 1.2 |
| | Curing agent F | | | | | | | |
| (D) Solvent | Solvent A | 7 | 7 | 7 | 7 | 7 | 7 | 7 |
| | Solvent B | | | | | | | |
| Weight ratio (A) / [(B) + (C)] | | 97.1/ 2.9 | 97.1/ 2.9 | 97.1/ 2.9 | 97.1/ 2.9 | 97.4/ 2.6 | 97.1/ 2.9 | 97.1/ 2.9 |
| Viscosity (Pa·sec) | | 390 | 600 | 580 | 500 | 520 | 530 | 630 |
| Specific resistance (µΩ·cm) | | 8684 | 14.2 | 28.6 | 13.2 | 17.4 | 11 | 5 |
| Printability | | Disconnection | Good | Good | Good | Good | Disconnection | Good |

**[Table 3]**

| | | Example 10 | Example 11 | Example 12 | Example 13 | Example 14 | Example 15 | Example 16 | Example 17 |
|---|---|---|---|---|---|---|---|---|---|
| (A) Conductive particles | Conductive particles A | 100 | 100 | 100 | 100 | 100 | 100 | 100 | 100 |
| | Conductive particles B | | | | | | | | |
| | Conductive particles C | | | | | | | | |
| | Conductive particles D | | | | | | | | |
| | Conductive particles E | | | | | | | | |
| | Conductive particles F | | | | | | | | |
| | Conductive particles G | | | | | | | | |
| | Conductive particles H | | | | | | | | |
| | Conductive particles I | | | | | | | | |
| | Conductive Particles J | | | | | | | | |
| (B) Epoxy resin | Epoxy resin A | 1.43 | 1.43 | 1.43 | 1.43 | 1.43 | 1.43 | 1.43 | 1.43 |
| | Epoxy resin B | | | | | | | | |
| (C) Curing agent | Curing agent A | 0.2 | 0.4 | | | 0.31 | 0.31 | | |
| | Curing agent B | | | 0.31 | | | | | |
| | Curing agent C | | | | 0.31 | | | | |
| | Curing agent D | | | | | | | 0.21 | 0.31 |
| | Curing agent E | 1.2 | 1.2 | 1.2 | 1.2 | | | | |
| | Curing agent F | | | | | 1.2 | | | |
| (D) Solvent | Solvent A | 7 | 7 | 7 | 7 | 7 | 7 | 7 | 7 |
| | Solvent B | | | | | | | | |
| Weight ratio (A) / [(B) + (C)] | | 97.2/2.8 | 97.1/ 2.9 | 97.1/ 2.9 | 97.1/ 2.9 | 97.1/ 2.9 | 98.3/ 1.7 | 98.4/ 1.6 | 98.3/1. 7 |
| Viscosity (Pa▪sec) | | 620 | 660 | 630 | 630 | 600 | 620 | 620 | 630 |
| Specific resistance (µΩ·cm) | | 5.2 | 5 | 5.4 | 5.6 | 5.7 | 7.5 | 6.6 | 6.6 |
| Printability | | Good | Good | Good | Good | Good | Good | Good | Good |

**[Table 4]**

| | | Example 18 | Example 19 | Example 20 | Example 21 | Example 22 | Example 23 | Example 24 | Example 25 |
|---|---|---|---|---|---|---|---|---|---|
| (A) Conductive particles | Conductive particles A | 100 | 70 | 50 | 30 | 80 | 100 | 100 | 100 |
| | Conductive particles B | | 30 | 50 | 70 | | | | |
| | Conductive particles C | | | | | | | | |
| | Conductive particles D | | | | | | | | |
| | Conductive particles E | | | | | | | | |
| | Conductive particles F | | | | | | | | |
| | Conductive particles G | | | | | | | | |
| | Conductive particles H | | | | | | | | |
| | Conductive particles I | | | | | 20 | | | |
| | Conductive Particles J | | | | | | | | |
| (B) Epoxy resin | Epoxy resin A | 1.43 | 1.43 | 1.43 | 1.43 | 1.43 | 1.43 | 1.43 | 1.43 |
| | Epoxy resin B | | | | | | | | |
| (C) Curing agent | Curing agent A | | 0.31 | 0.31 | 0.31 | 0.31 | 0.31 | 0.31 | 0.31 |
| | Curing agent B | | | | | | | | |
| | Curing agent C | | | | | | | | |
| | Curing agent D | 0.41 | | | | | | | |
| | Curing agent E | | 1.2 | 1.2 | 1.2 | 1.2 | 1.2 | 1.2 | 1.2 |
| | Curing agent F | | | | | | | | |
| (D) Solvent | Solvent A | 7 | 7 | 7 | 7 | ' 7 | 4 | ' 12 | |
| | Solvent B | | | | | | | | 7 |
| Weight ratio (A) / [(B) + (C)] | | 98.2/ 1.8 | 97.1/ 2.9 | 97.1/ 2.9 | 97.1/ 2.9 | 97.1/ 2.9 | 97.1/ 2.9 | 97.1/ 2.9 | 97.1/ 2.9 |
| Viscosity (Pa·sec) | | 620 | 580 | 500 | 480 | 620 | 770 | 380 | 560 |
| Specific resistance (µΩ·cm) | | 6.9 | 4.9 | 5.1 | 5 | 5.4 | 4.5 | 5.5 | 5.2 |
| Printability | | Good | Good | Good | Good | Good | Good | Good | Good |

**[Table 5]**

| Conductive particles (Conductive component: silver) | Model number | Manufacturing company | Organic component | Shape | Particle size (D50) (µm) | TAP Density (g/cm³) | BET specific surface area (m²/g) |
|---|---|---|---|---|---|---|---|
| Conductive particles A | AG-SNA-289 | DOWA | Salt of fatty acid ether and stearic acid | Spherical | 0.8 | 4.7 | 1.1 |
| Conductive particles B | AG-SNA-302 | DOWA | Salt of fatty acid ether and stearic acid | Spherical | 1.5 | 5.4 | 0.5 |
| Conductive particles C | AG-SNA-365 | DOWA | Salt of fatty acid ether and stearic acid | Spherical | 1.8 | 5.4 | 0.4 |
| Conductive particles D | AG-SNA-429 | DOWA | Salt of fatty acid ether and stearic acid | Spherical | 0.3 | 4.9 | 1.6 |
| Conductive particles E | AG-SNA-371 | DOWA | Benzotriazole and ricinoleic acid | Spherical | 0.3 | 3.5 | 1.9 |
| Conductive particles F | HXRAG-1 | Nippon Atomize Metal Powders Corporation | (none) | Spherical | 2.4 | 4.8 | 0.5 |
| Conductive particles G | AG-SNA-207 | DOWA | Oleic acid | Spherical | 1.5 | 5.0 | 0.4 |
| Conductive particles H | AG-SNA-201 | DOWA | Benzotriazole | Spherical | 1.4 | 4.6 | 0.6 |
| Conductive particles I | - | Namics | Oleic acid | Flaky | 2.0 | 5.3 | 0.7 |
| Conductive Particles J | - | Namics | Salt of fatty acid ether | Spherical | 1.2 | 3.4 | 0.4 |

**[Table 6]**

| Curing agent | Model number | Manufacturing company |
|---|---|---|
| Curing agent A | 2PHZ-PW | Shikoku Chemical Co., Ltd. |
| Curing agent B | 2P4MHZ-PW | Shikoku Chemical Co., Ltd. |
| Curing agent C | 2E4MZ | Shikoku Chemical Co., Ltd. |
| Curing agent D | Boron trifluoride monoethylamine complex | Fujifilm Wako Pure Chemical Corporation |
| Curing agent E | MEH8000H | Meiwa Kasei Co., Ltd. |
| Curing agent F | PSM4324 | Gunei Chemical Industry Co., Ltd. |

### Description of Reference Numerals

10: Crystalline silicon substrate
12: i-type amorphous silicon layer
14a: p-type amorphous silicon layer
14b: n-type amorphous silicon layer
16: Transparent conductive film
18a: Light incident side electrode
18b: Back side electrode

## Claims

1. A conductive paste for forming an electrode of a solar cell,
wherein the conductive paste comprises:
a conductive particles (A);
an epoxy resin (B); and
a curing agent (C),
the conductive particles (A) contain a conductive component and two or more organic components, and the conductive component is silver, and
the curing agent (C) contains at least one selected from an imidazole-based curing agent and a boron trifluoride compound.

2. The conductive paste according to claim 1, wherein the organic component comprises carboxylic acid.

3. The conductive paste according to claim 1, wherein the organic component comprises at least one selected from fatty acid ether or salt thereof and benzotriazole.

4. The conductive paste according to claim 1, wherein the organic component comprises carboxylic acid and at least one selected from fatty acid ether or salt thereof and benzotriazole.

5. The conductive paste according to claim 1, wherein the organic component comprises one or more organic component α and one or more organic component β,
the conductive particles (A) comprise the organic component α inside the conductive particles (A) and the organic component β on a surface of the conductive particles (A),
the organic component α comprises at least one selected from fatty acid ether, salt of fatty acid ether and benzotriazole.

6. The conductive paste according to claim 5, wherein the organic component β comprises stearic acid or ricinoleic acid.

7. The conductive paste according to any one of claims 3 to 6, wherein the fatty acid ether or the salt thereof comprises at least one selected from palmitic acid ether, myristic acid ether and oleic acid ether.

8. The conductive paste according to any one of claims 1 to 7, wherein a BET specific surface area of the conductive particles (A) is 0.3 to 3.5 m²/g.

9. The conductive paste according to any one of claims 1 to 8, wherein the conductive particles (A) comprise spherical conductive particles and a weight ratio of the spherical conductive particles in the conductive particles (A) is 80 weight % or more.

10. The conductive paste according to any one of claims 1 to 9, wherein a weight ratio of the conductive particles (A) and total weight of epoxy resin (B) and curing agent (C) (the weight of the conductive particles (A) : the total weight of epoxy resin (B) and curing agent (C)) is 98.5 : 1.5 to 93.0 : 7.0.

11. The conductive paste according to any one of claims 1 to 10, wherein the conductive paste comprises 0.1 to 5.0 parts by weight of the curing agent (C) when the total weight of the conductive particles (A) and the epoxy resin (B) is 100 parts by weight.

12. The conductive paste according to any one of claims 1 to 11, wherein the conductive paste further comprises a solvent (D).

13. The conductive paste according to any one of claims 1 to 12 for forming an electrode of a solar cell, wherein a wiring width of the electrode of the solar cell is 20 to 60 µm.

14. The electrode of the solar cell comprising the electrode having a wiring width of 20 to 60 µm in the solar cell, wherein the electrode is obtained by heat treatment of the conductive paste according to any one of claims 1 to 13.

15. The solar cell, wherein the electrode of the solar cell comprises a cured product obtained by heat treatment of the conductive paste according to any one of claims 1 to 13.
